# EUROPEAN PATENT SPECIFICATION

(11) **EP 1 926 580 B1**
(45) Date of publication and mention of the grant of the patent: **24.03.2010**
(21) Application number: 06757883.1
(22) Date of filing: 26.06.2006
(51) Int. Cl.: B28D 5/00, B23D 57/00, H01L 21/00

(54) **REDUCTION OF ATTRACTION FORCES BETWEEN SILICON WAFERS**
VERRINGERUNG VON ANZIEHUNGSKRÄFTEN ZWISCHEN SILIZIUMSCHEIBEN
RÉDUCTION DES FORCES D'ATTRACTION ENTRE DES TRANCHES DE SILICIUM

(30) Priority: 01.07.2005 US 695451 P
(43) Date of publication of application: 04.06.2008
(73) Proprietor: Rec Scanwafer AS, 3908 Porsgrunn (NO)
(72) Inventor: SAUAR, Erik, N-0375 Oslo (NO); WANG, Per Arne, N-3919 Porsgrunn (NO)
(74) Representative: Grünecker, Kinkeldey, Stockmair & Schwanhäusser Anwaltssozietät
(86) International application number: PCT/NO2006/000244
(87) International publication number: WO 2007/004890

(56) References cited:
- DE-A1- 10 220 468
- PATENT ABSTRACTS OF JAPAN vol. 2002, no. 06, 4 June 2002 (2002-06-04) -& JP 2002 036090 A (NIPPEI TOYAMA CORP; MITSUBISHI SILICON AMERICA CORP; MITSUBISHI MATERI), 5 February 2002 (2002-02-05)

## Description

The present invention comprises a method for reducing the attraction forces between wafers. The attraction forces are caused by fluid cohesion, material adhesion, surface tensions, viscous shear, etc. This attraction forces are reduced when the distance between adjacent wafers is increased.

Silicon wafers are generally produced by cutting thin slices (wafers) out of a larger silicon block by means of thin wires and a slurry containing abrasive particles. After the wafers have been sawed they are still glued (with adhesive bonding) to the carrying structure on one side. When this adhesive is released, the spacing between the wafers tends to collapse, and the surface forces between adjacent wafers make it difficult to pull the wafers apart without breaking them. The process of taking the wafers apart from each other is often referred to as singulation or separation.

In order to reduce the manufacturing costs of crystalline silicon wafers, the photovoltaic industry is continuously trying to reduce the wafer thickness. As a consequence of this, the surfaces of the wafers are also becoming flatter and flatter. Hence, the surface forces are expected to increase in the future, while the mechanical resistance of the wafers is reduced due to reduced thickness.

The method for reducing attraction forces between wafers according to the invention is **characterized in that** it comprises the step of, after sawing and before dissolution of the adhesive, introducing spacers between wafers.

By introducing spacers between the wafers before the adhesive is removed, a certain distance between the wafers will be maintained after the adhesive is removed. The major part of the above mentioned attraction forces will hence be reduced, and the wafers will be more easily separated from each other.

There are many possible ways to separate the wafers. The large majority of these methods (whether manual or automatic) will benefit from the addition of spacers.

In an embodiment of the invention the spacers consist of multiple bodies dispersed in a fluid. This fluid can be a liquid or gas, and in one embodiment of the invention, it comprises a wafer washing solution. It is also possible to introduce the spacers between wafers after washing, in this case the fluid need not be a wafer washing solution. In an embodiment of the invention, the fluid comprises a water based solution, and in a variant of this embodiment the fluid comprises 90% water. Other embodiments comprise fluid in the form of glycol based solutions, oil based solutions, etc.

The bodies are in one embodiment of the invention substantially spherical. In another embodiment, they are semi-spherical, or flake shaped or tubular. Any regular geometry for the bodies will in principle be satisfactory.

The size of the bodies can vary between 1 and 180 micrometers in diameter, and it is possible to introduce bodies with different diameters. Said bodies with different diameters can be introduced simultaneously (e.g. in the case where bodies with different diameters are dispersed in a fluid) or sequentially (that is introducing different fluids with bodies of substantially the same diameter for each fluid).
The density of the bodies will in one embodiment of the invention lie between 0,1g/cm³ and 3g/cm³. In a variant of this embodiment, the density will be between 0,5g/cm³ and 1,5g/cm³.

The invention comprises, apart from the above mentioned method, a method for wafer singulation and an agent for reducing attraction forces between wafers. The wafer singulation method according to the invention is **characterized in that** it comprises: 1) reducing the above mentioned attractive forces by introduction of spacers between wafers in a stack, 2) removing the end wafer from the stack, 3) repeating steps 1-2 for the next wafer in the stack.

The term "end wafer" in the present specification relates to a wafer situated on one end of the stack, independently of the stack's orientation (vertical or horizontal). This wafer will normally be called "upper" or "lower" wafer, which coincides with the wafer's actual position if the stack is vertical, but which does not coincide with this for wafers situated in a row (horizontal stack).

In one embodiment of the invention, the method comprises flushing the end wafer in the stack free for spacers. In a variant of this embodiment, the method comprises flushing only one surface of the end wafer, while in another embodiment it comprises flushing both surfaces of the end wafer.

The invention will now be described by means of an embodiment shown in the figures. This embodiment is only an example and is by no means limiting for the scope of the present application.

Figure 1 shows a silicon block after sawing.
Figure 2 shows spacers introduced between wafers.
Figure 3 shows the wafers after removal of the adhesive.

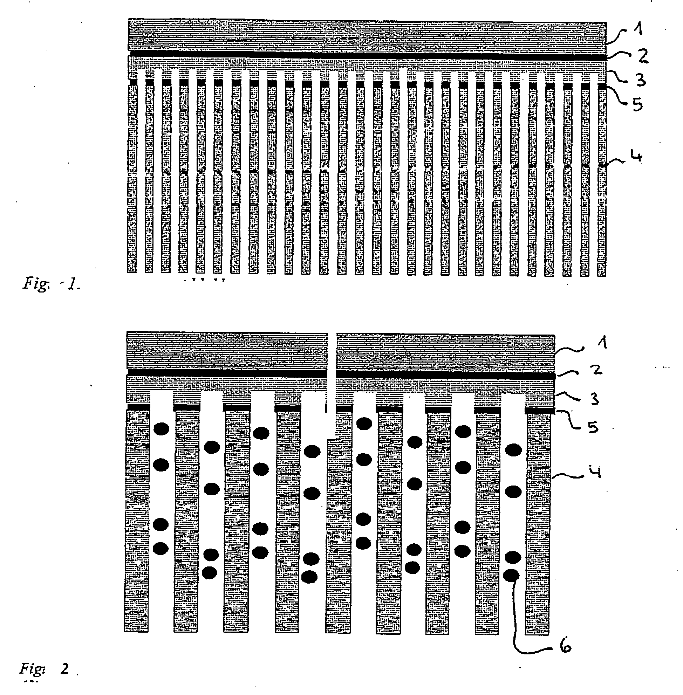

Figure 1 shows the point of departure for the method according to the invention. The block has been cut into slices 4 which are fastened to a glass sheet 3. Two layers of adhesive are present at this stage, a first layer 2 situated between a carrying structure 1 and a glass sheet 3 and a second layer 5 situated between glass sheet 3 and the individual slices 4.

Figure 2 shows how, before adhesive layer 5 is removed, spacers 6 are introduced between the wafers to keep these apart from one another, and thus reduce superficial attractive forces between them. In one embodiment of the invention, spacers 6 are particles dispersed in a fluid, which fluid can be gas or liquid. In the case said fluid is gas, it will be necessary to provide a fluid for washing the wafers after removal of adhesive layer 5. Spacers 6 are flushed into the interstices between wafers together with the fluid.

In an embodiment of the invention, the bodies are substantially spherical with a diameter of between 1 and 180 micrometers and with a density of between 0,5 g/cm³ and 2g/cm³. Possible materials for the bodies are plastic or glass. Other materials are e.g. alginate, synthetic polymers e.g. vinyl polymers, phenol microballs, monodisperse particles, silicon carbide particles. It is possible to operate with particles of approximately the same size, and also with different sizes of particles, which can be used simultaneously or sequentially.

Non-spherical bodies can also be used.

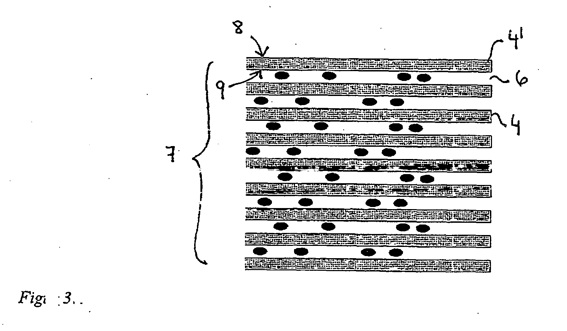

Figure 3 shows a stack of wafers with spacers provided in the interstices between wafers. In a singulation process according to the invention the upper (or the lower) wafer in the stack (4') is flushed on one or on both its upper (8) and lower (9) surface. After this the upper (or lower) wafer is removed from the stack. This step may be performed e.g. by pushing the wafer out of the stack by means of the flushing fluid or an auxiliary fluid.

Once the upper (or the lower) wafer is removed from the stack, the process is repeated for the next wafer in the stack.

## Claims

1. Method for reducing attraction forces between wafers cut out of a silicon block and bonded to a carrying structure (1) by means of an adhesive (5) on one side, **characterized in that** it comprises the step of before dissolution of the adhesive (5), introducing spacers (6) between wafers.

2. Method according to claim 1, **characterized in that** the spacers (6) consist of multiple bodies dispersed in a fluid.

3. Method according to claim 2, **characterized in that** the bodies are substantially spherical, semi-spherical or tubular.

4. Method according to claim 2, **characterized in that** the fluid is a liquid or a gas.

5. Method according to claim 2, **characterized in that** the fluid is a liquid with water contents equal to or higher than 90%.

6. Method according to claim 4, **characterized in that** the fluid consists of a wafer cleaning solution.

7. Method according to claim 2, **characterized in that** the spacers (6) have a size of between 1 and 180 micrometers.

8. Method according to claim 2, **characterized in that** it comprises simultaneously introducing spacers (6) with different or similar size.

9. Method according to claim 2, **characterized in that** it comprises sequentially introducing spacers (6) with different or similar size.

10. Method according to claim 2, **characterized in that** the density of the bodies is in the range of between 0,1g/cm³ and 3g/cm³.

11. Method according to claim 10, **characterized in that** the density of the bodies is in the range of between 0,5g/cm³ and 1,5g/cm³.

12. Wafer singulation method, **characterized in that** it comprises the following steps:
1) reducing wafer attraction forces in a stack of wafers by means of a method according to one of the preceding claims,
2) removing the end wafer from the stack,
3) repeating steps 1-2 for the next wafer in the stack.

13. Method according to claim 12, **characterized in** flushing the end wafer in the stack free for spacers (6) before removing the end wafer from the stack.

14. Wafer singulation method according to claim 13, **characterized in that** it comprises flushing one surface of the end wafer.

15. Wafer singulation process according to claim 13, **characterized in that** it comprises flushing both surfaces of the end wafer.

## Patentansprüche

1. Verfahren zum Verringern von Anziehungskräften zwischen Wafern, die aus einem Siliziumblock ausgeschnitten und an einer Trägerstruktur (1) mittels eines Klebstoffes (5) auf einer Seite angebracht werden, **dadurch gekennzeichnet, dass** es den Schritt des vor dem Auflösen des Klebstoffes (5) erfolgenden Einführens von Abstandshaltern (6) zwischen Wafern umfasst.

2. Verfahren nach Anspruch 1, **dadurch gekennzeichnet, dass** die Abstandshalter (6) aus mehreren in einem Fluid verteilten Körpern bestehen.

3. Verfahren nach Anspruch 2, **dadurch gekennzeichnet, dass** die Körper im Wesentlichen kugelförmig, halbkugelförmig oder rohrförmig sind.

4. Verfahren nach Anspruch 2, **dadurch gekennzeichnet, dass** das Fluid eine Flüssigkeit oder ein Gas ist.

5. Verfahren nach Anspruch 2, **dadurch gekennzeichnet, dass** das Fluid eine Flüssigkeit mit Wassergehalten von größer oder gleich 90% ist.

6. Verfahren nach Anspruch 4, **dadurch gekennzeichnet, dass** das Fluid aus einer Waferreinigungslösung besteht.

7. Verfahren nach Anspruch 2, **dadurch gekennzeichnet, dass** die Abstandshalter (6) eine Größe von zwischen 1 und 180 µm aufweisen.

8. Verfahren nach Anspruch 2, **dadurch gekennzeichnet, dass** es ein gleichzeitiges Einführen von Abstandshaltern (6) mit verschiedener oder ähnlicher Größe umfasst.

9. Verfahren nach Anspruch 2, **dadurch gekennzeichnet, dass** es ein nacheinander erfolgendes Einführen von Abstandshaltern (6) mit verschiedener oder gleicher Größe umfasst.

10. Verfahren nach Anspruch 2, **dadurch gekennzeichnet, dass** die Dichte der Körper in einem Bereich von zwischen 0,1 g/cm³ und 3 g/cm³ liegt.

11. Verfahren nach Anspruch 10, **dadurch gekennzeichnet, dass** die Dichte der Körper in einem Bereich von zwischen 0,5 g/cm³ und 1,5 g/cm³ liegt.

12. Wafervereinzelungsverfahren, **dadurch gekennzeichnet, dass** es die nachfolgenden Schritte umfasst:
(1) Verringern von Waferanziehungskräften in einem Stapel von Wafern mittels eines Verfahrens entsprechend einem der vorhergehenden Ansprüche,
(2) Entfernen des Endwafers von dem Stapel,
(3) Wiederholen der Schritte 1 und 2 für den nächsten Wafer in dem Stapel.

13. Verfahren nach Anspruch 12, **gekennzeichnet durch** ein Abstandshalter (6) entfernendes Abspülen des Endwafers in dem Stapel vor dem Entfernen des Endwafers von dem Stapel.

14. Wafervereinzelungsverfahren nach Anspruch 13, **dadurch gekennzeichnet, dass** es ein Abspülen einer Oberfläche des Endwafers umfasst.

15. Wafervereinzelungsverfahren nach Anspruch 13, **dadurch gekennzeichnet, dass** es ein Abspülen von beiden Oberflächen des Endwafers umfasst.

## Revendications

1. Procédé de réduction des forces d'attraction entre des tranches découpées d'un bloc de silicium et colées à une structure de support (1) au moyen d'un adhésif (5) d'un côté, **caractérisé en ce qu'**il comprend l'étape consistant, avant la dissolution de l'adhésif (5), à introduire des éléments d'espacement (6) entre les tranches.

2. Procédé selon la revendication 1, **caractérisé en ce que** les éléments d'espacement (6) consistent en de multiples corps dispersés dans un fluide.

3. Procédé selon la revendication 2, **caractérisé en ce que** les corps sont sensiblement sphériques, semi-sphériques ou tubulaires.

4. Procédé selon la revendication 2, **caractérisé en ce que** le fluide est un liquide ou un gaz.

5. Procédé selon la revendication 2**, caractérisé en ce que** le fluide est un liquide avec une teneur en eau égale ou supérieure à 90 %.

6. Procédé selon la revendication 4, **caractérisé en ce que** le fluide consiste en une solution de nettoyage de tranche.

7. Procédé selon la revendication 2, **caractérisé en ce que** les éléments d'espacement (6) ont une taille comprise entre 1 et 180 microns.

8. Procédé selon la revendication 2, **caractérisé en ce qu'**il comprend l'introduction simultanée d'éléments d'espacement (6) de tailles différentes ou similaires.

9. Procédé selon la revendication 2, **caractérisé en ce qu'**il comprend l'introduction séquentielle d'éléments d'espacement (6) de tailles différentes ou similaires.

10. Procédé selon la revendication 2, **caractérisé en ce que** la densité des corps est dans la plage de 0,1 g/cm³ à 3 g/cm³.

11. Procédé selon la revendication 10, **caractérisé en ce que** la densité des corps est dans la plage de 0,5 g/cm³ à 1, 5 g/cm³.

12. Procédé de singularisation de tranches, **caractérisé en ce qu'**il comprend les étapes suivantes consistant à :
1) réduire les forces d'attraction de tranches dans une pile de tranches au moyen d'un procédé selon l'une des revendications précédentes,
2) retirer la tranche terminale de la pile,
3) répéter les étapes 1 et 2 pour la tranche suivante de la pile.

13. Procédé selon la revendication 12, **caractérisé par** le rinçage de la tranche terminale de la pile pour éliminer les éléments d'espacement (6) avant le retrait de la tranche terminale de la pile.

14. Procédé de singularisation de tranches selon la revendication 13, **caractérisé en ce qu'**il comprend le rinçage d'une surface de la tranche terminale.

15. Procédé de singularisation de tranches selon la revendication 13, **caractérisé en ce qu'**il comprend le rinçage des deux surfaces de la tranche terminale.
